# EUROPEAN PATENT APPLICATION

(11) **EP 3 949 757 A1**
(43) Date of publication of application: **09.02.2022**
(21) Application number: 21188699.9
(22) Date of filing: 30.07.2021
(51) Int. Cl.: A23L 19/00, A23L 5/30, A23B 7/015, A23B 7/08, A23L 33/10, A23N 15/06, H03K 3/53

(54) **SWEETNESS ENHANCING METHOD AND APPARATUS FOR INFILTRATING STEVIOSIDE OR FRAGRANT INGREDIENT INTO FRUIT OR VEGETABLE BY USING HIGH-VOLTAGE PULSED ELECTRIC FIELD**

(30) Priority: 06.08.2020 KR 20200098369
(71) Applicant: Kim, Myoung Yeon, Gyuam-myeon, Buyeo-gun Chungcheongnam-do 33120 (KR)
(72) Inventor: Kim, Myoung Yeon, Gyuam-myeon, Buyeo-gun Chungcheongnam-do 33120 (KR)
(74) Representative: Nordic Patent Service A/S

(57) **Abstract**

The present disclosure relates to a technical idea of infiltrating stevioside or a fragrant ingredient into a fruit or vegetable by using a high-voltage pulsed electric field, and a method for enhancing the sweetness according to an embodiment may comprise the steps of maintaining high-voltage pulse device electrodes installed on at least two sides in a container containing a solution in which a natural sugar or a substance for fragrance is dissolved, injecting an object of the fruit or vegetable between the high-voltage pulse device electrodes, receiving an alternating current from the high-voltage pulse device electrodes to convert the alternating current into a high-voltage direct current, and storing the high-voltage direct current in a capacitor, which is an energy storage device, to charge energy, generating a high-voltage pulsed electric field (PEF) by discharging the charged energy from the high-voltage pulse device electrodes using a pulse generating circuit when the injected object is sensed, forming a potential difference in cell membranes of the object with the generated high-voltage pulsed electric field, and allowing the solution to permeate between the generated perforations of the cell membranes by maintaining the state in which the potential difference is formed for a predetermined time until perforations are generated in the cell membranes of the object.

## Description

### BACKGROUND OF THE DISCLOSURE

### Field of the disclosure

The present disclosure relates to a technical idea of infiltrating stevioside or a fragrant ingredient into a fruit or vegetable by using a high-voltage pulsed electric field.

### Related Art

Conventionally, materials for increasing the sugar content of a fruit to enhance the sweetness have been composed of solutions prepared by dissolving at least one of brown sugar, fructose, sugar refined saccharose, and glucose in water, and have included a solution for increasing the sugar content of the fruit before harvesting of a fruit, the solution sprayed or added to the soil (for example, Japanese Patent Laid-Open Publication No. 2002-345340, hereinafter, referred to as Patent Document 1), or a fruit bag containing an ethylene gas adsorbent (for example, Japanese Patent Laid-Open Publication No. 2000-37142, hereinafter, referred to as Patent Document 2).

However, there has been a problem that the solution for increasing the sugar content of a fruit described in Patent Document 1 and the fruit bag described in Patent Document 2 are used before harvesting, but do not improve the sugar content of the fruit after harvest. In addition, although the fruit bag can prevent oxidative injury by suppressing the production of ethylene in the fruit since the fruit bag described in Patent Document 2 adsorbs an ethylene gas, there has also been a problem that there is a concern that the fruit bag deteriorates the taste by excessively suppressing the production of ethylene and suppressing the ripening of the fruit.

In addition, although a method of increasing the sugar content of a fruit provides excellent sweetness characteristics in order to enhance the sweetness that is generally used, there has been a problem that it is not suitable for most of the modern people who have a sedentary working lifestyle and are sensitive to calories as the sugar content of the fruit is high in sugar and calories.

It has been known that, as a representative example of vegetables after harvest with low sugar content, a tomato is rich in lycopene, beta-carotene, and the like which are antioxidants, and can reduce the incidence of prostate cancer by 45% and is excellent in an anti-cancer effect and an effect of increasing resistance to cold virus stress if you eat 10 or more tomatoes a week. However, there is a problem that this tomato is not tasty since a sweetness of the tomato is 4.1 to 5.5 brix, which is lower than that of oriental melon of about 13 brix, that of grape of 13 to 21 brix, and that of apple of 13 to 14 brix. For this reason, it has been investigated that the annual tomato consumption per person in Korea is 7 kg, which is significantly lower than 140 kg of Greece. In general, it has been common to sprinkle salt or sugar, or stevia sugar, i.e., a processed product of stevioside that is an extract of leaves of stevia, which is a kind of herb, on a vegetable or fruit with low sugar content such as a tomato to eat the vegetable or fruit having the salt or sugar sprinkled thereon, or the vegetable or fruit having the stevia sugar sprinkled thereon. However, a problem of health due to overdose of sodium and sugar as well as a problem of calories are constantly emerging from the above-mentioned salt or sugar.

In order to solve the problems of the related art, there is a demand for a technology of enhancing the sweetness of a vegetable or fruit after harvest with low sugar content even without damaging the surface thereof.

### [Prior Art Documents]

### [Patent Documents]

Japanese Patent Laid-Open Publication No. 2002-345340
Japanese Patent Laid-Open Publication No. 2000-37142

### SUMMARY

An object of the present disclosure is to provide a method for enhancing the sweetness of a fruit or vegetable, the method capable of enhancing the sweetness by infiltrating stevioside into a vegetable or fruit after harvest with low sugar content without damaging the surface thereof.

The other object of the present disclosure is to provide a fruit or vegetable with enhanced sweetness.

A method for enhancing the sweetness according to an embodiment may comprise the steps of maintaining high-voltage pulse device electrodes installed on at least two sides in a container containing a solution in which a natural sugar or a substance for fragrance is dissolved, injecting a fruit or vegetable between the high-voltage pulse device electrodes, receiving an alternating current from the high-voltage pulse device electrodes to convert the alternating current into a high-voltage direct current, and storing the high-voltage direct current in a capacitor, which is an energy storage device, to charge energy, generating a high-voltage pulsed electric field (PEF) by discharging the charged energy from the high-voltage pulse device electrodes using a pulse generating circuit when the injected object is sensed, forming a potential difference in cell membranes of the fruit or vegetable with the generated high-voltage pulsed electric field, and allowing the solution to permeate between the generated perforations of the cell membranes by maintaining the state in which the potential difference is formed for a predetermined time until perforations are generated in the cell membranes of the fruit or vegetable.

A solution according to an embodiment is characterized in that it is a liquid in which stevioside, a health supplementary ingredient, or a substance for fragrance ingredients is dissolved in a set concentration.

A fruit or vegetable according to an embodiment is a tomato, and the step of allowing the solution to permeate improves the potential difference from 10 mV to 1 V for 0.1 to 10 ms until the perforations are generated in the cell membranes of the tomato, and allows the perforations of the cell membrane to be generated at about 1 V.

An apparatus for enhancing the sweetness according to an embodiment includes a container containing a solution in which a natural sugar or a substance for fragrance is dissolved, high-voltage pulse device electrodes installed on at least two sides in the container, a sensor determining whether or not a fruit or vegetable is between the high-voltage pulse device electrodes, a high-voltage pulse generator controlling the high-voltage pulse device electrodes so that high voltage pulses are generated from the high-voltage pulse device electrodes when the fruit or vegetable is injected, a charger charging energy by storing the high-voltage direct current in a capacitor that is an energy storage device after converting the alternating current into a high-voltage direct current by providing an alternating current by the generated high voltage pulses, and a high-voltage PEF generator generating a high-voltage pulsed electric field (PEF) by discharging the charged energy from the high-voltage pulse device electrodes using a pulse generating circuit when the injected object is sensed, wherein a potential difference is formed in cell membranes of the fruit or vegetable by the generated high-voltage pulsed electric field, and when the potential difference is formed until perforations are generated in the cell membranes of the object, the solution permeates between the generated perforations of the cell membranes.

The foregoing solution according to an embodiment is characterized in that it is a liquid in which stevioside, a health supplementary ingredient, or a substance for fragrance ingredients is dissolved in a set concentration.

A fruit or vegetable according to an embodiment is a tomato, and the high-voltage PEF generator improves the potential difference from 10 mV to 1 V for 0.1 to 10 *µ*s until the perforations are generated in the cell membranes of the tomato, and allows the perforations of the cell membranes to be generated at about 1 V.

### BRIEF DESCRIPTION OF THE DRAWINGS

FIG. 1 is a drawing illustrating an apparatus for enhancing the sweetness for an object according to an embodiment.
FIG. 2 is a drawing more specifically illustrating a PEF application device of an apparatus for enhancing the sweetness for an object according to an embodiment.
FIG. 3 is a drawing illustrating a method of perforating cell walls and cell membranes through a high-voltage pulsed electric field targeting a tomato among fruits or vegetables according to an embodiment.
FIG. 4 shows the stevia infiltration amount (EC concentration) with respect to the frequency and number of pulses of an electric field targeting a tomato among fruits or vegetables according to an embodiment.
FIG. 5 is a drawing more specifically illustrating a method for enhancing the sweetness of a fruit or vegetable according to an embodiment.

### DESCRIPTION OF EXEMPLARY EMBODIMENTS

Hereinafter, embodiments will be described in detail with reference to the accompanying drawings. However, the scope of the patent application is not limited or restricted by these embodiments. The same reference numerals presented in each drawing indicate the same member.

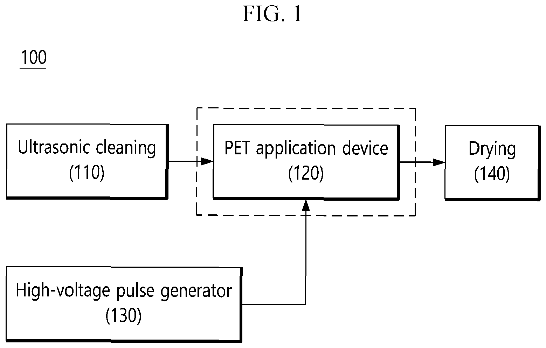

FIG. 1 is a drawing illustrating an apparatus 100 for enhancing the sweetness for an object such as a fruit or a vegetable according to an embodiment.

A method for enhancing the sweetness of a fruit or vegetable using an apparatus 100 for enhancing the sweetness may enhance the sweetness in a simple manner by infiltrating stevioside into the vegetable or fruit after harvest with low sugar content without damaging the surface of the fruit or vegetable.

To this end, an apparatus 100 for enhancing the sweetness according to an embodiment may include a PEF application device 120 operated by triggering of a high-voltage pulse generator 130.

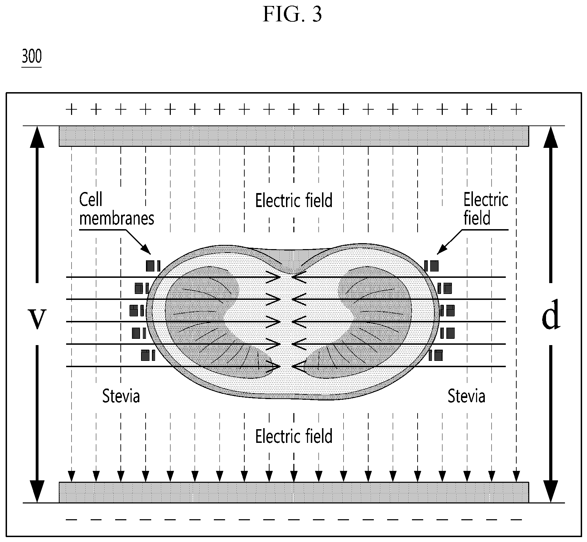

Further, the PEF application device 120 may include a container, high-voltage pulse device electrodes, and a sensor, and will be described more specifically in FIG. 3 below.

Referring back to FIG. 1, when a fruit or vegetable is cleanly washed through the process of ultrasonic cleaning 110, the cleanly washed fruit or vegetable may be injected into the PEF application device 120.

The PEF application device 120 senses entry of the fruit or vegetable, and at this time, the high-voltage pulse generator 130 may generate a high-voltage PEF by discharging the charged energy using a pulse generating circuit with respect to the entered fruit or vegetable.

Moreover, a potential difference may be formed in cell membranes of an object while maintaining the PEF at a certain strength or higher for a certain period of time.

As the potential difference to be formed is maintained for a certain period of time, perforations may be generated in the cell membranes of the object. Thereafter, a solution containing the object may permeate between the generated perforations of the cell membranes.

Meanwhile, in the present disclosure, a tomato was used as an example among the objects, and in order to allow the solution to permeate the inside of the tomato, a PEF application device 120 according to the present disclosure may improve a potential difference from 10 mV to 1 V for 0.1 to 10 *µ*s until perforations are generated in cell membranes of the tomato, and may maintain the potential difference so that the perforations of the cell membranes are generated at about 1 V.

To this end, the solution may be interpreted as a liquid in which a substance such as stevioside, a health supplementary ingredient, or a fragrance ingredient is dissolved in a set concentration.

For example, although stevioside, as a substance extracted from stevia that is a kind of herb, is able to make a sweet taste 300 times sweeter than sugar, it is a natural sweetener which not only is discharged without being absorbed by the body, but also has no sugar. As a method of infiltrating such stevioside into an object after harvest with low sugar content, a method of infiltrating stevioside using a syringe, a method of cutting the object to infiltrate stevioside into the object, and other methods are variously being studied.

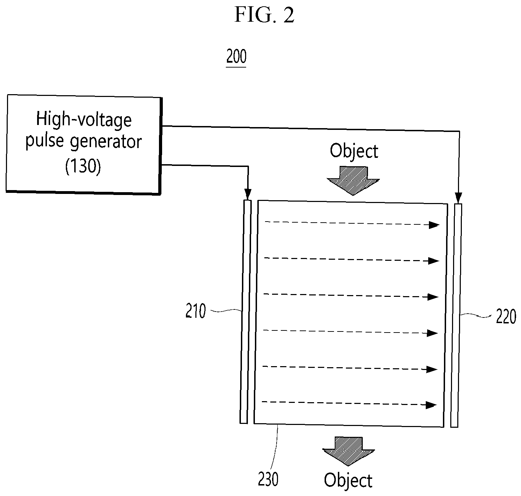

FIG. 2 is a drawing more specifically illustrating a PEF application device 200 of an apparatus for enhancing the sweetness for an object according to an embodiment.

Although stevioside, as a substance extracted from stevia that is a kind of herb, makes a sweet taste 300 times sweeter than sugar, it is a natural sweetener which not only is discharged without being absorbed by the body, but also has no sugar. Stevioside may be injected into the object by dissolving stevioside in water without cutting the object or injecting stevioside into the object using a syringe in order to infiltrate stevioside into an object, thereby opening cell walls and cell membranes of the object using a high-voltage PEF.

Through this, the consumption amount may be increased by processing an object including a tomato having excellent sweet taste.

The PEF application device 200 may include a container 230 and high-voltage pulse device electrodes 210 and 220, and the high-voltage pulse device electrodes 210 and 220 may refer to electrodes which are adjacent to the container so as to be installed on at least two sides of the container. In addition, a sensor may control the high-voltage pulse device electrodes so that the high-voltage pulse device electrodes generate high voltage pulses when the object is injected by determining whether or not the object is between the high-voltage pulse device electrodes.

FIG. 3 is a drawing illustrating a method of perforating cell walls and cell membranes through a high-voltage pulsed electric field.

As shown in FIG. 3, it is a drawing showing a method of manufacturing a processed tomato among examples of an object by a high-voltage pulsed electric field (PEF) method of the present disclosure.

The present disclosure, as a technology of adding sweetness, fragrance, or medicinal ingredients to an object including tomato, can process a sweet-tasting tomato or object by generating a high-voltage pulsed electric field (PEF) on the surface thereof to open cell membranes and cell walls and infiltrating the dissolved stevioside into the tomato or object.

In the present disclosure, a high-voltage pulse generator, an electrode plate, and a tomato or object injecting and discharger are configured to infiltrate stevioside dissolved in water into the tomato or object.

In the present disclosure, after putting a number of tomatoes in a water tank in which stevioside dissolved in water and the electrode plate are installed, high voltage pulses are applied for 0.1 to 10 *µ*s to generate perforations in the cell walls and cell membranes, and stevioside dissolved in water is infiltrated between the perforations.

Since, as an object for enhancing the sweetness in the object loading step, any types of the object may be used as long as it is necessary to enhance the sweetness of the object, the types of the object may be variously design-changed.

For example, stevioside may be applied more effectively to a vegetable or fruit with low sugar content such as tomato.

Stevioside may be more easily infiltrated into the inside of the object.

A solution containing stevioside may be a solution prepared by mixing 1 L of water with 0.5 to 5 g of stevioside.

There is almost no change in sweetness in the object when the number of cycles is too few, while there may be a problem that a target fruit or vegetable bursts or the surface thereof is damaged when the number of the cycles is too many.

In addition, it is better to maintain the internal temperature of an apparatus 100 for enhancing the sweetness or the temperature of the solution in a temperature range of 25 to 30 °C in order to maintain the freshness of the object.

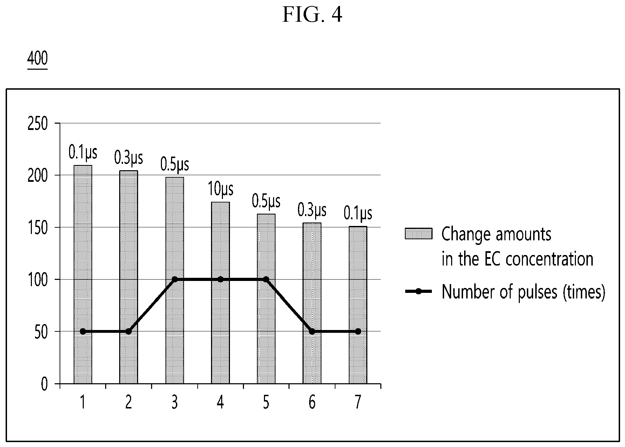

FIG. 4 is a graph 400 showing the stevia infiltration amount (EC concentration) with respect to the frequency and number of pulses of an electric field targeting a tomato among examples of an object.

When examining the graph 400, it shows results of measuring change amounts in the EC concentration while generating 50 to 100 pulses per time and varying the pulse generation time per pulse from 0.1 to 10 *µ*s.

As results of the measurement, it is the section where the perforation of cell walls and cell membranes starts when the high-voltage pulsed electric field is generated up to 1 to 3 times, and it is the section where stevioside is infiltrated between the perforated cell walls and cell membranes when the high-voltage pulsed electric field is generated up to 4 to 7 times.

As results of measuring EC values while infiltrating stevioside into the tomato by installing an EC sensor, injecting a tomato between a positive (+) plate and a negative (-) plate of the high-voltage pulsed electric field, and generating high voltage pulses, thereby forming an electric field, it can be seen that, as the EC concentration measured values are lowered from 208 to 150 ppm, the electric field is formed with high voltage pulses to generate perforations in the cell walls and cell membranes, and stevioside is infiltrated into the tomato between the perforations.

In [Table 1] below, the measured EC concentration values before/after stevia infiltration are presented in a table.

The EC concentration of an original object corresponds to the EC concentration before stevia infiltration, and the stevia processing EC concentration corresponds to the EC concentration after stevia infiltration.

**[Table 1]**

| | EC concentration of an original object | Stevia processing EC concentration |
|---|---|---|
| 1 | 209 | 151 |
| 2 | 207 | 147 |
| 3 | 214 | 155 |
| 4 | 200 | 149 |
| 5 | 208 | 152 |
| 6 | 207 | 150 |
| 7 | 210 | 152 |
| 8 | 211 | 157 |
| 9 | 208 | 150 |
| 10 | 207 | 150 |

Electrical conductivity (EC) values of a tomato with enhanced sweetness measured by an EC water quality concentration meter (manufacturer: Litecom, Co., Ltd., model name: HD416) may be in a range of 145 to 160 µs/cm. This is because stevioside is infiltrated into the tomato and the tomato concentration becomes thick so that the tomato has a considerably low electrical conductivity. More specifically, as it can be confirmed that a tomato having a low electrical conductivity has a sweeter taste, it is expected that a tomato suitable for consumer preferences may be provided.

Through this, the present disclosure enables the tomato or object to processed into a delicious object by infiltrating a stevioside solution into a portion that lacks sweetness for a tomato or object.

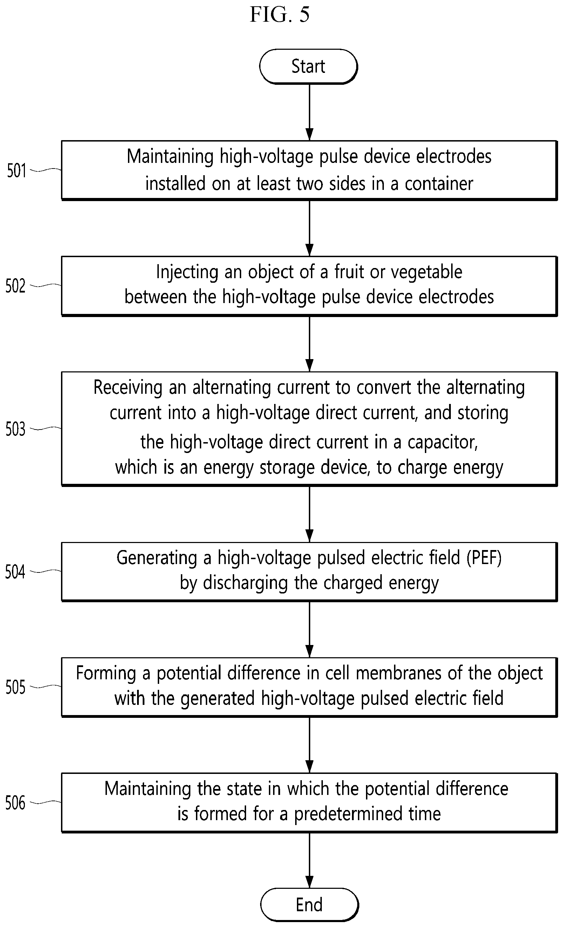

FIG. 5 is a drawing more specifically illustrating a method for enhancing the sweetness for an object according to an embodiment.

In a method for enhancing the sweetness for an object according to an embodiment, high-voltage pulse device electrodes installed on at least two sides of the container may be maintained in a container containing a solution in which a natural sugar or a substance for fragrance is dissolved (step 501).

For example, the above-mentioned effect may be further improved by using a mixed solution prepared by mixing 1 L of water with 0.5 to 5 g of stevioside as a solution containing stevioside.

In addition, in a method for enhancing the sweetness for an object according to an embodiment, the object of a fruit or vegetable may be injected between high voltage pulses (step 502).

The step 502 may be interpreted as a step of loading the object, wherein as an object for enhancing the sweetness in the object loading step, any types of a fruit or vegetable may be used as long as it is necessary to enhance the sweetness thereof. For example, it may be applied more effectively to a vegetable or fruit with low sugar content such as a tomato.

In a method for enhancing the sweetness for an object according to an embodiment, energy may be charged by storing the high-voltage direct current in a capacitor, which is an energy storage device, after converting the alternating current into a high-voltage direct current by receiving an alternating current from high-voltage pulse device electrodes (step 503).

In addition, in a method for enhancing the sweetness for an object according to an embodiment, a high-voltage pulsed electric field (PEF) may be generated by discharging the charged energy from the high-voltage pulse device electrodes using a pulse generating circuit when the injected object is sensed (step 504).

In a method for enhancing the sweetness for an object according to an embodiment, a potential difference may be formed in cell membranes of the object by the generated high-voltage PEF (step 505).

In a method for enhancing the sweetness for an object according to an embodiment, the solution may be allowed to permeate between the generated perforations of the cell membranes by maintaining the state in which the potential difference is formed for a predetermined time until perforations are generated in the cell membranes of the object (step 506).

The process of injecting the solution into such an object may be repeated several cycles. However, there is almost no change in sweetness of the object when the number of cycles is too few, while there may be a problem that a target fruit or vegetable bursts or the surface thereof is damaged when the number of the cycles is too many.

In addition, it is better to maintain the internal temperature of an apparatus for enhancing the sweetness or the temperature of the solution in a temperature range of 25 to 30 °C in order to maintain the freshness of the object.

Hereby, when the present disclosure is used, a method for enhancing the sweetness of an object has an effect of enabling the sweetness to be enhanced by infiltrating stevioside into the object after harvest with low sugar content without damaging the surface of the object in a simple manner.

In addition, when the present disclosure is used, a method for enhancing the sweetness of an object can easily adjust the degree of sweetness of the object, thereby having an effect of enabling consumer preferences to be variously satisfied.

In other words, an object of which sweetness is enhanced by a method for enhancing the sweetness of an object according to the present disclosure has an effect of having very good marketability by enhancing the sweetness even without damaging the surface thereof. In addition, since only sweetness is enhanced without increasing calories or sugar content of the object, the object has a beneficial effect on the health.

According to an embodiment, a method for enhancing the sweetness of a fruit or vegetable can enhance the sweetness in a simple manner by infiltrating stevioside into the vegetable or fruit after harvest with low sugar content without damaging the surface of the fruit or vegetable.

According to an embodiment, a method for enhancing the sweetness of a fruit or vegetable can easily adjust the degree of sweetness of the fruit or vegetable, thereby enabling consumer preferences to be variously satisfied.

According to an embodiment, a fruit or vegetable of which sweetness is enhanced by a method for enhancing the sweetness of a fruit or vegetable has an effect of having very good marketability by enhancing the sweetness even without damaging the surface thereof.

According to an embodiment, since only sweetness is enhanced without increasing calories or sugar content of a fruit or vegetable, the fruit or vegetable has a beneficial effect on the health.

## Claims

1. A sweetness enhancing method for infiltrating stevioside into an object without damaging the surface of the object, the sweetness enhancing method comprising the steps of:
maintaining high-voltage pulse device electrodes installed on at least two sides in a container containing a solution in which a natural sugar or a substance for fragrance is dissolved;
injecting an object of a fruit or vegetable between the high-voltage pulse device electrodes;
receiving an alternating current from the high-voltage pulse device electrodes to convert the alternating current into a high-voltage direct current, and storing the high-voltage direct current in a capacitor, which is an energy storage device, to charge energy;
generating a high-voltage pulsed electric field (PEF) by discharging the charged energy from the high-voltage pulse device electrodes using a pulse generating circuit when the injected object is sensed;
forming a potential difference in cell membranes of the object with the generated high-voltage pulsed electric field; and
allowing the solution to permeate between the generated perforations of the cell membranes by maintaining the state in which the potential difference is formed for a predetermined time until perforations are generated in the cell membranes of the object.

2. The sweetness enhancing method of claim 1, wherein the solution is a liquid in which stevioside, a health supplementary ingredient, or a substance for fragrance ingredients is dissolved in a set concentration.

3. The sweetness enhancing method of claim 1, wherein the object is a tomato.

4. The sweetness enhancing method of claim 3, wherein the step of allowing the solution to permeate improves the potential difference from 10 mV to 1 V for 0.1 to 10 *µ*s until the perforations are generated in the cell membranes of the object, and allows the perforations of the cell membrane to be generated at about 1 V.

5. An apparatus for enhancing the sweetness including:
a container containing a solution in which a natural sugar or a substance for fragrance is dissolved;
high-voltage pulse device electrodes installed on at least two sides in the container;
a sensor determining whether or not an object of a fruit or vegetable is between the high-voltage pulse device electrodes;
a high-voltage pulse generator controlling the high-voltage pulse device electrodes so that high voltage pulses are generated from the high-voltage pulse device electrodes when the object is injected;
a charger charging energy by storing the high-voltage direct current in a capacitor that is an energy storage device after converting the alternating current into a high-voltage direct current by providing an alternating current by the generated high voltage pulses; and
a high-voltage PEF generator generating a high-voltage pulsed electric field (PEF) by discharging the charged energy from the high-voltage pulse device electrodes using a pulse generating circuit when the injected object is sensed, wherein a potential difference is formed in cell membranes of the object by the generated high-voltage pulsed electric field, and when the potential difference is formed until perforations are generated in the cell membranes of the object, the solution permeates between the generated perforations of the cell membranes.

6. The method of claim 5, wherein the solution is a liquid in which stevioside, a health supplementary ingredient, or a substance for fragrance ingredients is dissolved in a set concentration.

7. The method of claim 5, wherein the object is a tomato, and the high-voltage PEF generator improves the potential difference from 10 mV to 1 V for 0.1 to 10 *µ*s until the perforations are generated in the cell membranes of the object, and allows the perforations of the cell membranes to be generated at about 1 V.
